# DEMANDE DE BREVET EUROPEEN

(11) **EP 3 958 327 A1**
(43) Date de publication de la demande: **23.02.2022**
(21) Numéro de dépôt: 21187535.6
(22) Date de dépôt: 23.07.2021
(51) Int. Cl.: H01L 29/66, H01L 29/36, B82Y 10/00, B82Y 40/00, H01L 29/423, H01L 21/265, H01L 21/266, H01L 21/308

(54) **PROCEDE DE REALISATION D'UN DISPOSITIF QUANTIQUE A QUBITS DE SPIN NUCLEAIRE**

(30) Priorité: 17.08.2020 FR 2008524
(71) Demandeur: Commissariat à l'énergie atomique et aux énergies alternatives, 75015 Paris (FR)
(72) Inventeur: HUTIN, Louis, 38054 GRENOBLE CEDEX 09 (FR); BORREL, Julien, 38420 LE VERSOUD (FR); TIRON, Raluca, 38054 GRENOBLE CEDEX 09 (FR)
(74) Mandataire: Brevalex

(57) **Abrégé**

Procédé de réalisation d'un dispositif (100) quantique, comportant :
- réalisation, sur une couche nanofil semi-conductrice (104), d'un guide (106) de grapho-épitaxie formant une cavité, avec une longueur perpendiculaire au nanofil semi-conductrice (104) et une largeur de dimension latérale correspondant à un multiple d'une période d'auto-assemblage en lamelles d'un copolymère diblocs ;
- premier dépôt du copolymère dans la cavité ;
- premier auto-assemblage du copolymère, formant un premier arrangement (111) alterné de premières lamelles (112) et de deuxièmes lamelles (114), les premières et deuxièmes lamelles orientés perpendiculairement au nanofil (104) ;

- retrait des premières lamelles ;
- implantation de dopants dans des parties de la couche semi-conductrice précédemment recouvertes par les premières lamelles ;
- retrait des deuxièmes lamelles ;
- dépot d'un matériau de grille (120);
- deuxième dépôt du copolymère dans la cavité (108), sur le matériau de grille (120) ;
- deuxième auto-assemblage du copolymère, formant un deuxième arrangement alterné de premières et deuxièmes lamelles (122, 124) ;
- retrait des deuxièmes lamelles (124);
- gravure de portions du matériau de grille précédemment recouvertes par les deuxièmes lamelles.

## Description

### DOMAINE TECHNIQUE ET ART ANTÉRIEUR

Le domaine technique de l'invention est celui de l'électronique quantique utilisant des qubits de spins nucléaires formés dans un matériau semi-conducteur. L'invention porte notamment sur la réalisation d'un dispositif quantique comprenant des qubits de spin nucléaires, ce dispositif pouvant former un ordinateur quantique.

Le document de B. E. Kane, « A silicon-based nuclear spin quantum computer », Nature 393, 133-137, 14 mai 1998, propose la réalisation d'un ordinateur quantique comprenant des qubits de spin nucléaire réalisés dans une couche de silicium. La structure de cet ordinateur quantique requiert la réalisation d'un réseau d'atomes donneurs, ou dopants, de phosphore uniques (c'est-à-dire un seul atome donneur, ou dopant, dans la région de semi-conducteur de chaque qubit) espacés régulièrement les uns des autres d'une distance égale à environ 20 nm et formés dans une couche de silicium 28 isotopiquement purifiée. Les atomes donneurs sont disposés de préférence à une profondeur constante dans la couche de semi-conducteur. Dans un tel dispositif, chaque qubit est encodé par le spin nucléaire d'un des atomes donneurs. La couche de silicium est recouverte d'une couche d'oxyde de silicium servant d'oxyde de grille. Des premières grilles sont réalisées chacune au-dessus d'un des atomes donneurs et permettent de rendre le spin nucléaire de ces atomes sensible ou non à un signal d'excitation magnétique fourni par une antenne. Des deuxièmes grilles sont également positionnées sur la couche de silicium, entre les premières grilles, pour contrôler chacune des barrières tunnel séparant deux atomes donneurs voisins.

Des améliorations d'une telle structure d'ordinateur quantique ont été proposées, comme par exemple celles décrites dans les documents C. D. Hill et al., « A surface code quantum computer in silicon », Science Advances, 1, 9 (30 octobre 2015) et G. Tosi et al., « Silicon quantum processor with robust long-distance qubit couplings », Nature Communications, 8, 450, 6 septembre 2017. Les structures proposées dans ces documents comportent des réseaux bidimensionnels de qubits, rendant ainsi ces structures compatibles avec des codes de correction d'erreur. Ces structures se complexifient pour intégrer des détecteurs de charge ou du couplage à longue distance.

Pour toutes ces structures, la principale difficulté de leur réalisation réside dans l'implantation précise des dopants qui doit être mise en œuvre dans la couche de semi-conducteur, et dans la réalisation des grilles de commande qui doivent être réalisées précisément, c'est-à-dire alignées, au-dessus des dopants.

Le document de T. Shinada et al., « Enhancing semiconductor device performance using ordered dopant arrays », Nature 437, 1128-1131 (20 octobre 2005) décrit un procédé de réalisation d'arrangements ordonnés de dopants uniques dans une couche de semi-conducteur, au cours duquel un faisceau d'ions est tronqué pour réaliser des implantations de dopants uniques avec une précision d'environ 100 nm par rapport aux emplacements visés. Une grille est ensuite formée en recouvrant toute la matrice de dopants réalisée. Ce procédé ne permet pas de réaliser plusieurs grilles de commande chacune disposée précisément au-dessus d'un des dopants.

Le document de S. R. Schofield et al., « Atomically Precise Placement of Single Dopants in Si », Phys. Rev. Lett. 91, 136104, 25 septembre 2003, propose, pour réaliser une implantation de dopants uniques dans une couche de silicium, de passiver tout d'abord la surface de la couche de silicium avec des atomes d'hydrogène. La pointe d'un microscope à effet tunnel (STM) est ensuite utilisée pour éliminer les liaisons hydrogène une par une au niveau de chacun des emplacements souhaités pour les dopants. La couche de silicium est ensuite exposée à du PH₃ qui se fixe sur la région de la couche où les liaisons hydrogène ont été éliminées. L'atome de P diffuse ensuite dans le silicium par un recuit mis en œuvre à une température inférieure à celle de désorption des liaisons hydrogène. Toutes ces étapes sont réalisées dans l'enceinte du microscope à effet tunnel. Bien que cette méthode permette un placement très précis des dopants dans le silicium, elle est aussi extrêmement lente, ce qui la rend incompatible avec une mise en œuvre industrielle en raison du très faible rendement de production pouvant être obtenu avec ce procédé.

Le document de J. J. Pla et al., « A single-atom electron spin qubit in silicon », Nature 489, 541-545, 27 septembre 2012, décrit la réalisation d'un qubit de spin d'électron lié à un atome de phosphore dans du silicium. Pour cela, une implantation ionique de phosphore est réalisée dans une fenêtre de dimensions égales à 90 x 90 nm² définie par lithographie électronique dans un masque de PMMA (Polyméthacrylate de méthyle). L'implantation est mise en œuvre avec une dose ajustée pour qu'un ou quelques dopants arrivent dans la cavité formée par la fenêtre. Le niveau de grille est ensuite réalisé en alignant les grilles avec des marques d'alignement utilisées lors de l'implantation. Avec ce procédé, un bon alignement entre les dopants et les grilles est toutefois difficile à obtenir.

Le document de M. Koch et al., « Spin read-out in atomic qubits in an all-epitaxial three-dimensional transistor », Nature Nanotechnology, 7 janvier 2019, décrit un procédé dans lequel la lithographie par STM est utilisée non seulement pour localiser des dopants uniques dans une couche de silicium, mais aussi pour réaliser des électrodes (sous la forme de monocouches de silicium dopées P) sur plusieurs niveaux. Une couche de silicium épitaxiée sépare le dispositif à dopant unique d'une grille supérieure. Des marques gravées permettent d'obtenir un alignement avec une précision d'environ 5 nm entre les motifs des différentes couches. Ce procédé est très précis mais très lent, ce qui le rend incompatible avec une mise en œuvre industrielle.

### EXPOSÉ DE L'INVENTION

Un but de la présente invention est de proposer un procédé de réalisation d'un dispositif quantique à qubits de spin nucléaire ne présentant pas les inconvénients des procédés précédemment décrits, c'est-à-dire permettant d'obtenir un très bon alignement entre des dopants, ou atomes donneurs, implantés et des grilles de commande réalisés au-dessus des dopants, pouvant être mis en œuvre industriellement, et qui soit compatible avec la réalisation de réseaux, linéaires ou bidimensionnels, de qubits pour que le dispositif réalisé soit compatible avec des codes de correction d'erreur.

Pour cela, il est proposé un procédé de réalisation d'un dispositif quantique à qubits de spin nucléaire, comportant la mise en œuvre des étapes suivantes :
- réalisation, sur une face d'une couche de semi-conducteur, d'un guide de grapho-épitaxie, ou guide d'assemblage, formant au moins une cavité ;
- premier dépôt d'un copolymère à blocs dans la cavité du guide de grapho-épitaxie ;
- premier auto-assemblage du copolymère à blocs, formant dans la cavité du guide de grapho-épitaxie un premier arrangement d'au moins un premier motif formé par une première phase du copolymère à blocs et d'au moins un deuxième motif formé par une deuxième phase du copolymère à blocs ;
- retrait du premier motif du premier arrangement, ou retrait de la première phase du copolymère à blocs du premier arrangement ;
- implantation de dopants dans des parties de la couche de semi-conducteur découvertes lors du retrait du premier motif du premier arrangement ;
- retrait du deuxième motif du premier arrangement, ou retrait de la deuxième phase du copolymère à blocs du premier arrangement ;
- deuxième dépôt du copolymère à blocs donné dans la cavité du guide de grapho-épitaxie, recouvrant au moins un matériau de grille réalisé sur la couche de semi-conducteur entre le retrait du deuxième motif du premier arrangement et le deuxième dépôt du copolymère à blocs, ou avant la réalisation du guide de grapho-épitaxie ;
- deuxième auto-assemblage du copolymère à blocs, formant dans la cavité du guide de grapho-épitaxie un deuxième arrangement d'au moins un premier motif formé par la première phase du copolymère à blocs et d'au moins un deuxième motif formé par la deuxième phase du copolymère à blocs, similaires à ceux du premier arrangement ;
- retrait du deuxième motif du deuxième arrangement, ou retrait de la deuxième phase du copolymère à blocs du deuxième arrangement ;
- gravure de premières portions du matériau de grille découvertes lors du retrait du deuxième motif du deuxième arrangement, telle que des deuxièmes portions restantes du matériau de grille localisées sous le premier motif du deuxième arrangement forment des grilles de commande des qubits ;
- retrait du premier motif du deuxième arrangement, ou retrait de la première phase du copolymère à blocs du deuxième arrangement.

Ce procédé propose d'utiliser les propriétés d'auto-assemblage dirigé de copolymères à blocs (« Directed Self-Assembly » en anglais, ou DSA), et la grapho-épitaxie pour obtenir un auto-alignement entre les emplacements d'implantation des dopants et les emplacements des grilles de commande des qubits. Cet auto-alignement est obtenu grâce à la réalisation successive de deux arrangements similaires de motifs d'un copolymère à blocs obtenus par deux auto-assemblages successifs du copolymère à blocs dans un même guide de grapho-épitaxie. Du fait que la forme et les dimensions du guide sont similaires au cours des deux auto-assemblages, les deux arrangements de motifs obtenus sont également similaires. Les motifs des deux arrangements sont judicieusement utilisés pour réaliser successivement un masque d'implantation des dopants et un masque de gravure pour la réalisation des grilles de commande. Les propriétés d'auto-assemblage du copolymère à blocs garantissent donc l'obtention d'un auto-alignement entre les dopants implantés et les grilles de commande réalisées.

En outre, ce procédé est compatible avec une mise en œuvre industrielle, contrairement aux procédés de l'art antérieur devant être mis en œuvre dans un STM.

L'auto-assemblage dirigé du copolymère à blocs permet de générer des motifs de très hautes résolution et de forte densité. Ainsi, ce procédé permet par exemple la réalisation de qubits espacés les uns des autres d'une distance égale à environ 40 nm, et par exemple réalisés sous la forme d'une matrice bidimensionnelle, rendant le dispositif compatible avec la mise en œuvre de codes de correction d'erreurs.

Un copolymère à blocs est un polymère dans lequel plusieurs unités de répétition de monomères, par exemple un monomère A et un monomère B dans le cas d'un copolymère diblocs, forment des chaînes liées entre elles par une liaison covalente. En donnant suffisamment de mobilité aux chaînes, par exemple en chauffant ce copolymère à blocs, les chaînes de monomères A ont tendance à se séparer en phases ou blocs et à se réorganiser sous des conformations spécifiques, qui dépendent notamment du ratio entre les monomères. Par exemple, le ratio entre le monomère A et le monomère B d'un copolymère diblocs peut être adapté pour que l'auto-assemblage des chaînes produise des première et deuxième phases disposées sous la forme d'un arrangement alterné de lamelles du monomère A et de lamelles du monomère B.

Des détails de mise en œuvre d'auto-assemblage de copolymères à blocs sont décrits par exemple dans le document « Guided self-assembly of block-copolymer for CMOS technology: a comparative study between grapho-epitaxy and surface chemical modification », L. Oria et al., SPIE 2011, Vol. 7970-24.

Le copolymère à blocs peut être un copolymère dibloc.

La cavité peut comporter, dans un plan parallèle à la face de la couche de semi-conducteur sur laquelle le guide est réalisé, une dimension latérale égale à un multiple d'une période d'auto-assemblage en lamelles du copolymère à blocs, et dans lequel les premier et deuxième arrangements correspondent à des arrangements alternés de premières lamelles correspondant au premier motif et de deuxièmes lamelles correspondant au deuxième motif.

La cavité du guide de grapho-épitaxie peut avoir une section, dans le plan parallèle à la face de la couche de semi-conducteur, de forme rectangulaire.

La couche de semi-conducteur peut être disposée sur un substrat, et le procédé peut comporter en outre, avant la réalisation du guide de grapho-épitaxie, une gravure de la couche de semi-conducteur telle qu'au moins une portion restante de la couche de semi-conducteur forme un nanofil ayant une plus grande dimension qui est parallèle à la dimension latérale de la cavité.

Toutefois, il est possible que la couche de semi-conducteur ne soit pas gravée pour former un nanofil, en particulier lorsque des copolymères non lamellaires sont utilisés.

En outre, l'implantation de dopants réalisée peut être adaptée à la réalisation de boîtes quantiques.

Dans ce cas, le procédé peut comporter en outre la mise en œuvre d'un dopage de parties de la couche de semi-conducteur différentes de celles découvertes lors du retrait du premier motif du premier arrangement. Ce dopage peut servir à former les réservoirs de porteurs entre lesquels les boîtes quantiques (grilles de commande + dopants implantés) formant les qubits sont disposées.

Le premier auto-assemblage et/ou le deuxième auto-assemblage du copolymère à blocs peut comporter la mise en œuvre d'un recuit du copolymère à blocs. Ce recuit est notamment mis en œuvre à une température et pendant une durée engendrant l'assemblage du copolymère à blocs. Ces paramètres du recuit dépendent donc directement du copolymère à blocs choisi.

L'implantation de dopants peut comporter la mise en œuvre d'une implantation ionique.

Le matériau de grille peut être réalisé sur la couche de semi-conducteur entre le retrait du deuxième motif du premier arrangement et le deuxième dépôt du copolymère à blocs et peut comporter du polysilicium, ou le matériau de grille peut être réalisé sur la couche de semi-conducteur avant la réalisation du guide de grapho-épitaxie et peut comporter du polysilicium et/ou un matériau métallique dont l'épaisseur soit telle que l'implantation de dopants puisse être réalisée à travers le matériau de grille. Lorsque le matériau de grille est réalisé sur la couche de semi-conducteur avant la réalisation du guide de grapho-épitaxie, le ou les matériaux utilisés pour former le matériau de grille et la ou les épaisseurs de ce ou ces matériaux sont choisis tels que l'implantation de dopants puisse être réalisée à travers ce ou ces matériaux de grille. Le matériau métallique peut être avantageusement un matériau supraconducteur, par exemple du TiN dont l'épaisseur est inférieure ou égale à environ 10 nm.

Le procédé peut comporter un dépôt d'une couche de masque dur sur le matériau de grille avant le deuxième dépôt du copolymère à blocs, et le procédé peut comporter en outre, entre le retrait du deuxième motif du deuxième arrangement et la gravure des premières portions du matériau de grille, une gravure de parties de la couche de masque dur précédemment recouvertes par le deuxième motif du deuxième arrangement.

La couche de semi-conducteur peut comporter du silicium 28 isotopiquement purifié.

Les dopants implantés dans les premières parties de la couche de semi-conducteur peuvent correspondre à des atomes de phosphore.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

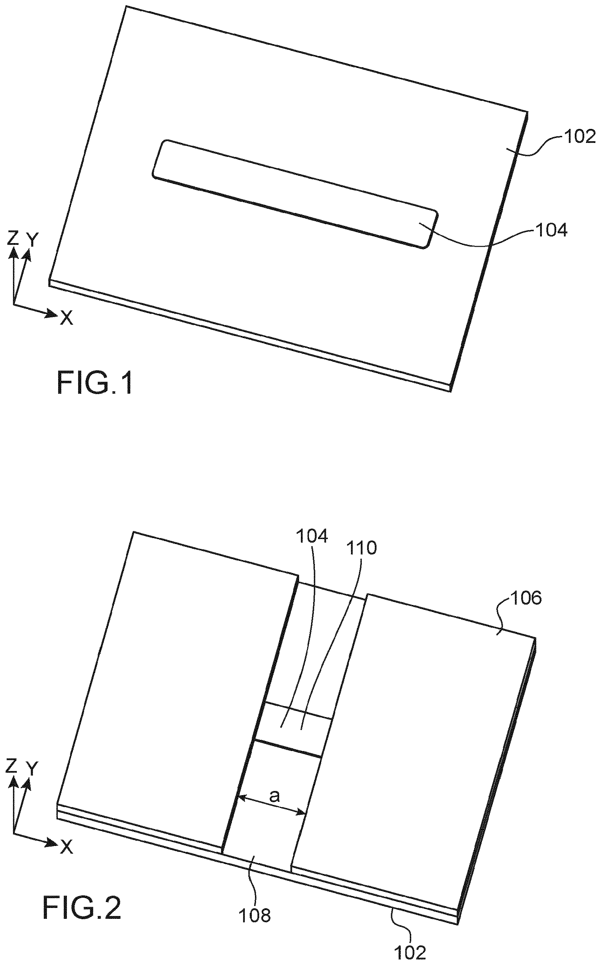

- les figures 1 à 14 représentent les étapes d'un procédé de réalisation d'un dispositif quantique à qubits de spin nucléaire selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Un procédé de réalisation d'un dispositif quantique 100 à qubits de spin nucléaire selon un mode de réalisation particulier est décrit ci-dessous en lien avec les figures 1 à 14.

Le dispositif 100 est réalisé à partir d'une couche de semi-conducteur dans laquelle les qubits de spin nucléaire vont être réalisés sous la forme de boîtes quantiques. Le semi-conducteur de cette couche est avantageusement du silicium, et notamment du ²⁸Si isotopiquement purifié. Du ²⁸Si est par exemple obtenu par épitaxie en utilisant un précurseur silane ²⁸SiH₄ obtenu par exemple par centrifugation de SiF₄ en ²⁸SiF₄, puis par réduction du ²⁸SiF₄ en ²⁸SiH₄.

La couche de semi-conducteur est ici disposée sur un substrat 102 comprenant un matériau diélectrique ou isolant électriquement, par exemple du SiO₂. Par exemple, la couche de semi-conducteur peut correspondre à la couche superficielle de silicium d'un substrat SOI (silicium sur isolant).

Dans le mode de réalisation particulier décrit ici, la couche de semi-conducteur est gravée, par exemple en mettant en œuvre une photolithographie puis une gravure de cette couche, telle qu'au moins une portion restante de la couche forme un nanofil 104 (voir figure 1). Sur la figure 1, le nanofil 104 comporte une plus grande dimension parallèle à l'axe X. Les dimensions du nanofil 104, dans un plan parallèle à la face du substrat 102 sur laquelle se trouve le nanofil 104 (plan parallèle au plan (X,Y) sur la figure 1), sont par exemple comprise entre environ 100 nm et 10 µm. De plus, l'épaisseur de la couche de semi-conducteur, et donc du nanofil 104, est par exemple comprise entre environ 5 nm et 20 nm.

En variante, la couche de semi-conducteur peut ne pas être gravée.

Un guide de grapho-épitaxie 106 est ensuite réalisé sur la couche de semi-conducteur. Sur la figure 2, étant donné que la couche de semi-conducteur a été gravée pour former le nanofil 104, le guide 106 est réalisé sur des parties du nanofil 104 et des parties du substrat 102.

Le guide 106 forme au moins une cavité 108 disposée en regard de la région de semi-conducteur dans laquelle les qubits de spin sont destinés à être réalisés, et qui correspond au motif de guidage du guide 106. Sur la figure 2, la cavité 108 est localisée en regard d'une partie centrale 110 du nanofil 104 dans laquelle des dopants vont être implantés et des grilles réalisées pour former les boîtes quantiques du dispositif 100.

Sur l'exemple de la figure 2, la cavité 108 a une section, dans un plan parallèle à la face du nanofil 104 ou du substrat 102 sur laquelle le guide 106 est réalisé, de forme rectangulaire. Les plus petits côtés de cette section sont ici parallèles à l'axe X et la dimension de ces côtés (ou dimensions latérale), qui correspond à la largeur de la cavité 108, porte la référence « a » sur la figure 2. De manière générale, la largeur de la cavité 108 peut être comprise entre environ 50 nm et 10 µm et la cavité 108 peut comporter une longueur (dimension parallèle à l'axe y) par exemple comprise entre environ 50 nm et 10 µm. L'épaisseur du guide 106, et donc de la cavité 108, est par exemple égale à environ 60 nm, et plus généralement comprise entre environ 20 nm et 200 nm.

Le guide 106 comporte une ou plusieurs couches de matériaux. Le guide 106 comporte par exemple du TiN et/ou SiO₂ et/ou du SiN. Le ou les matériaux utilisés pour réaliser le guide 106 sont choisis tels qu'ils présentent une bonne sélectivité vis-à-vis des agents de gravure qui seront utilisés par la suite pour graver un copolymère à blocs. Le nombre et l'épaisseur des couches du guide 106 sont également susceptibles de varier, selon la nature du copolymère à blocs et les techniques de gravure utilisées.

Le guide 106 est par exemple réalisé en mettant en œuvre des étapes de dépôt du ou des matériaux du guide 106 recouvrant la couche de semi-conducteur (ou le nanofil 104 et le substrat 102) avec le ou les matériaux destinés à former le guide 106, de photolithographie (par exemple de type Extrême UltraViolet ou EUV, ou Deep UltraViolet ou DUV, ou par faisceau d'électrons ou « e-beam », ou nanoimpression, etc.) et de gravure de ce matériau.

Dans la suite du procédé, un copolymère à blocs sera déposé dans la cavité 108, puis auto-assemblé pour former un premier arrangement d'au moins un premier motif formé par une première phase du copolymère à blocs et d'au moins un deuxième motif formé par une deuxième phase du copolymère à blocs.

Dans l'exemple de réalisation décrit ici en lien avec les figures 1 à 14, le copolymère à blocs utilisé correspond à un copolymère diblocs destiné à être auto-assemblé pour former un premier arrangement alterné de lamelles comprenant des premières et deuxièmes phases du copolymère et orientées parallèlement les unes des autres. Pour obtenir un tel arrangement, le guide 106 est réalisé tel que la largeur « a » de la cavité 108 soit égale à un multiple de la période d'auto-assemblage en lamelles du copolymère diblocs qui sera utilisé. Ainsi, le guide 106 est réalisé tel que a = n.L₀, avec L₀ correspondant à la période d'auto-assemblage en lamelles du copolymère diblocs qui sera assemblé, et n correspondant à un nombre entier naturel choisi notamment en fonction du nombre de qubits à réaliser dans le nanofil 104. Par exemple, n peut être compris entre environ 2 et 20.

Le copolymère diblocs est ensuite déposé dans la cavité 108. Le copolymère diblocs comprend deux monomères A et B formant, après un auto-assemblage, un arrangement alterné de première lamelles comprenant une première phase du copolymère diblocs auto-assemblé et de deuxième lamelles comprenant une deuxième phase du copolymère diblocs auto-assemblé.

Les monomères A et B sont par exemple choisis parmi ceux de la liste ci-dessous :
PS-b-PDMS :polystyrène-bloc-polydiméthylsiloxane; PS-b-PDMSB; PMMA-b-PDMSB; PS-b-PMAPOSS : Polystyrene-b-poly(methyl acrylate)POSS; PMMA-b-PMAPOSS: Poly(methyl methacrylate)-b-poly(methyl acrylate)POSS ; PS-b-PFS: Poly(styrene)-b- poly(ferrocenyldimethylsilane) ; PS-b-Pl-b-PFS: Poly(styrene)-b-poly(isoprene)-b-poly(ferrocenyldimethylsilane) ; P2VP-b-PDMS: Poly(2-vinylpyridine)-b-poly(dimethyl siloxane) ; PTMSS-b-PLA : poly(trimethylsilylstyrene)-b-poly(D,L-lactide); PS-b-PDMS : Poly(styrene)-b-poly(dimethylsiloxane); PLA-b-PDMS: poly(D,L-lactide)-b-poly(dimethylsiloxane) ; PAcOSt-b-PSi2St : Poly(4-acetoxystyrene)-b-poly(4-(Bis(trimethylsilyl)methyl)styrene); PS-b-P(DMS-r-VMS): Polystyrene-b-poly(dimethylsiloxane-r-vinylmethylsiloxane); 1,2-PB-b-PDMS : 1,2-polybutadiene-b-poly(dimethyl siloxane) ; PS-b-PLA : polystyrène-bloc-acide polylactique ; PS-b-PEO : polystyrène-bloc-polyoxyde d'éthylène ; PS-b-PMMA-b-PEO : polystyrène-bloc-polyméthylméthacrylate-bloc-polyoxyde d'éthylène ; PS-b-P2VP : polystyrène-bloc-poly(2vinylpyridine) ; PTMSS-b-PMOST poly(trimethylsilylstyrene)-blockpoly(4-methoxystyrene) ; PtBS-b-PMMA : poly(4 tert butyl styrene)-b- Poly(methyl methacrylate) ; PCHE-b- PMMA polycyclohexane-b- Poly(methyl methacrylate) ; PS-b-P4VP: polystyrène-bloc-poly(4vinylpyridine) ; PTMSS-b-PDLA ; PS-b-PFS ; PS-b-MH.

Le copolymère diblocs est par exemple déposé par un dépôt à la tournette, ou « spin-coating », ou en variante par un dépôt chimique en vase vapeur, ou CVD.

Le copolymère à blocs déposé dans la cavité 108 est ensuite auto-assemblé. Cet auto-assemblage correspond par exemple à la mise en œuvre d'un traitement thermique de type recuit pendant une durée comprise entre environ 1 min et 30 min, à une température comprise entre environ 200°C et 250°C. Selon un exemple particulier, le recuit est mis en œuvre pendant environ 2 min à 230°C. La température et la durée du recuit sont avantageusement optimisées en fonction de l'épaisseur de la couche de copolymère à blocs déposée dans la cavité 108. Plus la couche de copolymère est épaisse, plus la durée et/ou la température du recuit sera importante. Par exemple, pour une couche de copolymère diblocs de type PS-b-PMMA d'épaisseur égale à 20 nm, le recuit peut être mis en œuvre pendant une durée d'environ 2 min. Lorsque cette couche a une épaisseur égale à 150 nm, la durée du recuit peut être égale à environ 15 min.

En variante, suivant le copolymère utilisé, l'auto-assemblage peut être obtenu par un traitement différent d'un recuit, par exemple une exposition à une atmosphère de solvant ou une exposition à la lumière.

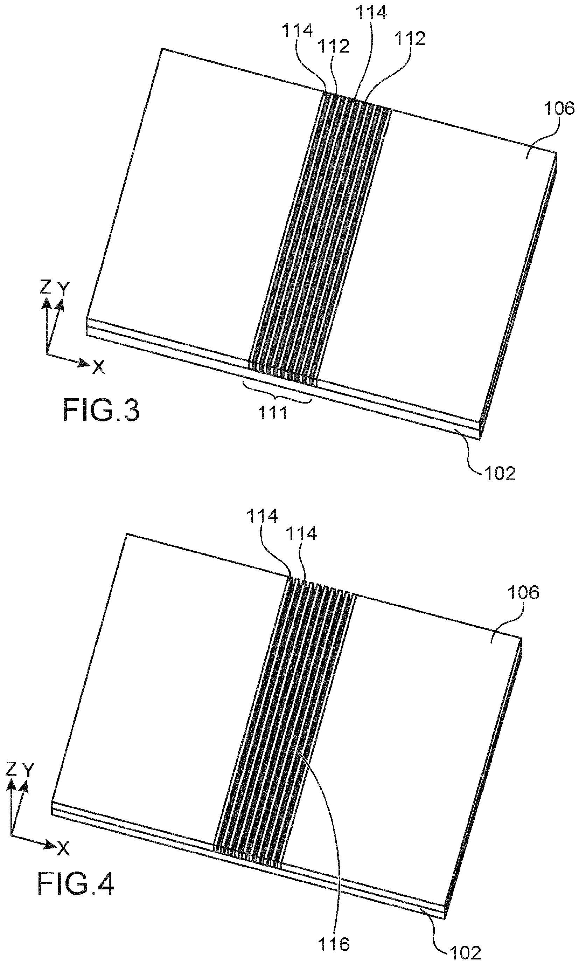

Avec la mise en œuvre de l'auto-assemblage, le copolymère diblocs forme un premier arrangement 111 alterné de premières lamelles 112 comprenant une première phase du copolymère diblocs assemblé et de deuxièmes lamelles 114 comprenant une deuxième phase du copolymère diblocs assemblé (voir figure 3). Les premières et deuxièmes lamelles 112, 114 sont orientées dans le sens de la longueur de la cavité 108, c'est-à-dire comportent leur plus grande dimension orientée perpendiculairement à la largeur « a » de la cavité 108. Cet agencement et cette orientation des premières et deuxièmes lamelles 112, 114 est obtenu du fait que la valeur de la largeur « a » de la cavité 108 est égale à un multiple de la période L₀ d'auto-assemblage en lamelles du copolymère diblocs utilisé. La largeur (dimension selon l'axe X dans l'exemple décrit ici) de chacune des premières et deuxièmes lamelles 112, 114 obtenues est par exemple égale à environ 20 nm. Plus généralement, la largeur de chacune des premières et deuxièmes lamelles 112, 114 est fonction notamment de la masse molaire du copolymère diblocs utilisé. Plus cette masse molaire est importante, plus la largeur des lamelles 112, 114 est importante. La longueur des premières et deuxièmes lamelles 112, 114 est égale à la longueur de la cavité 108.

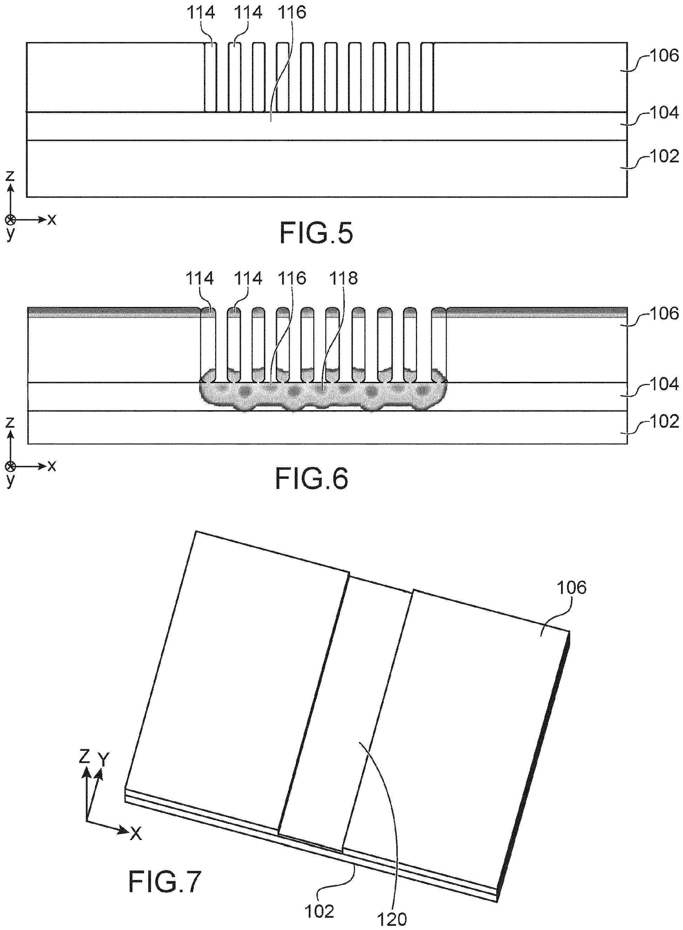

Un retrait des premières lamelles 112 est ensuite réalisé (voir figure 4). Ce retrait est réalisé en mettant en œuvre une gravure qui soit sélective par rapport aux deuxièmes lamelles 114, et également sélective vis-à-vis du ou des matériaux du guide 106 afin de ne pas endommager le guide 106. Une telle gravure correspond par exemple à une gravure par plasma. Selon un exemple particulier, lorsque les premières lamelles 112 comportent du PMMA et que les deuxièmes lamelles 114 comportent du PS, un plasma O₂ peut être utilisé pour retirer les premières lamelles 112. A l'issue de cette gravure, des parties 116 du nanofil 104 (ou de la couche de semi-conducteur lorsque cette couche n'est pas gravée préalablement à la réalisation du guide 106) ne sont plus recouvertes par les premières lamelles 112, chaque partie 116 du nanofil 104 étant précédemment recouverte par une seule des premières lamelles 112. La figure 5 représente une vue en coupe de la structure obtenue à ce stade dans un plan de coupe parallèle au plan (X,Z) et passant par le nanofil 104.

Des dopants sont ensuite implantés dans les parties 116 du nanofil 104. Les dopants implantés correspondent par exemple à des atomes de phosphore. En variante, d'autres types de dopants peuvent être implantés, comme par exemple des atomes de ²⁰⁹Bi ou de ⁷⁷Se.

Cette implantation de dopants peut être réalisée par implantation ionique. Dans ce cas, la dose, l'angle du faisceau incident (également appelé « tilt ») et l'énergie du faisceau sont choisis pour n'avoir qu'un seul dopant, ou à défaut un nombre restreint de dopants et proche de 1, et avantageusement inférieur à 10, dans chacune des parties 116 du nanofil 104. Par exemple, lorsque les deuxièmes lamelles 114 ont une épaisseur égale à environ 60 nm, l'implantation ionique peut être mise en œuvre avec une énergie comprise entre environ 1 et 10 keV, avec un angle d'inclinaison compris entre 0 et 7°, et avec une dose comprise entre 1.10¹¹ et 1.10¹² at/cm².

La figure 6 représente une image de simulation montrant des dopants 118 implantés dans les parties 116 du nanofil 104.

Les deuxièmes lamelles 114 sont ensuite retirées, par exemple par une gravure par plasma O₂.

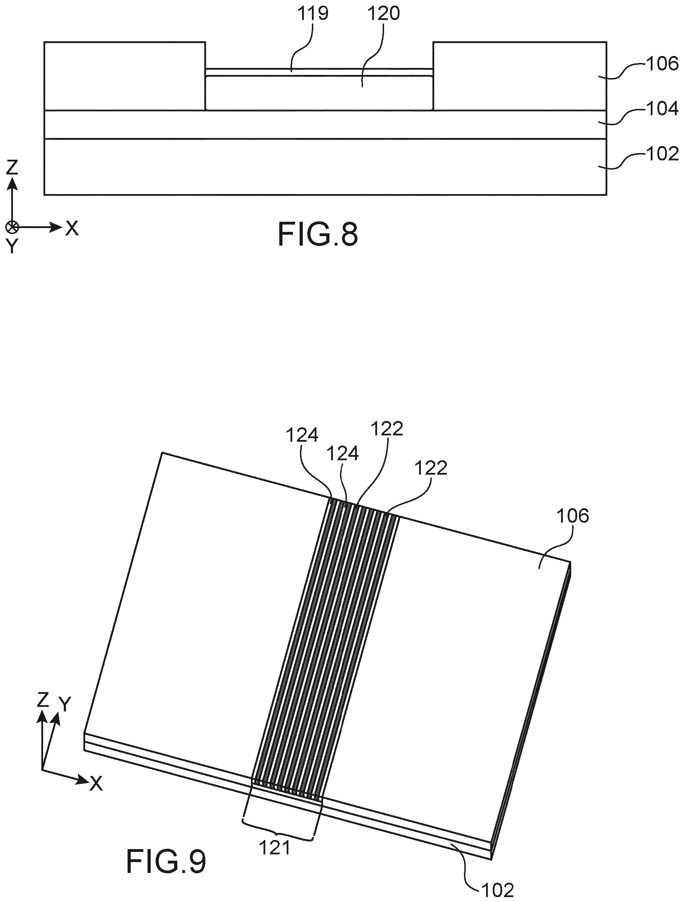

Un matériau de grille est ensuite formé dans la cavité 108 sous la forme d'une portion 120 (voir figures 7 et 8). Pour former cette portion 120, le matériau de grille est par exemple déposé dans la cavité 108 et sur l'ensemble du guide 106. Une planarisation mécano-chimique est ensuite mise en œuvre pour supprimer le matériau de grille présent sur le guide 106, en dehors de la cavité 108. Un retrait sélectif du matériau de grille peut ensuite être mis en œuvre afin de retirer une partie de l'épaisseur restante du matériau de grille, afin d'obtenir l'épaisseur souhaitée pour les futures grilles du dispositif 100. Ce matériau de grille est électriquement conducteur et correspond par exemple à du polysilicium.

Le matériau de grille recouvre un diélectrique de grille formé sur le nanofil 104 (ou sur la couche de semi-conducteur lorsque cette couche n'est pas gravée préalablement à la réalisation du guide 106) préalablement au dépôt du matériau de grille.

Suivant la nature du matériau de grille, il est possible qu'un masque dur soit réalisé sur ce matériau de grille préalablement à sa gravure. C'est le cas notamment lorsque le matériau de grille est du polysilicium. Ainsi, comme représenté sur la figure 8, la portion 120 du matériau de grille est recouverte d'une couche 119 de masque dur qui comporte par exemple du SiO₂ et/ou du SiN.

Après la réalisation de la portion 120 de matériau de grille (et éventuellement de la couche 119), le copolymère à blocs précédemment utilisé est de nouveau utilisé pour former un deuxième arrangement de motifs de phases différentes du copolymère similaire au premier arrangement précédemment réalisé.

Dans l'exemple de réalisation décrit ici, le copolymère diblocs est déposé dans la cavité 108, sur la portion 120 de matériau de grille (ou sur la couche 119 si celle-ci recouvre le matériau de grille). Un auto-assemblage de ce copolymère diblocs est ensuite mis en œuvre, par exemple dans les mêmes conditions que celles précédemment décrites pour former le premier arrangement 111. A l'issue de cet assemblage, le copolymère diblocs auto-assemblé forme un deuxième arrangement 121 alterné de premières lamelles 122 comprenant une première phase du copolymère diblocs auto-assemblé et de deuxièmes lamelles 124 comprenant une deuxième phase du copolymère diblocs auto-assemblé (voir figure 9). Les premières et deuxièmes lamelles 122, 124 sont identiques aux premières et deuxièmes lamelles 112, 114 précédemment réalisées du fait que le copolymère diblocs utilisé, ainsi que la forme et les dimensions (notamment la largeur « a ») du guide 106 sont identiques à ceux utilisés lors de l'auto-assemblage du copolymère diblocs ayant formé les premières et deuxièmes lamelles 112, 114.

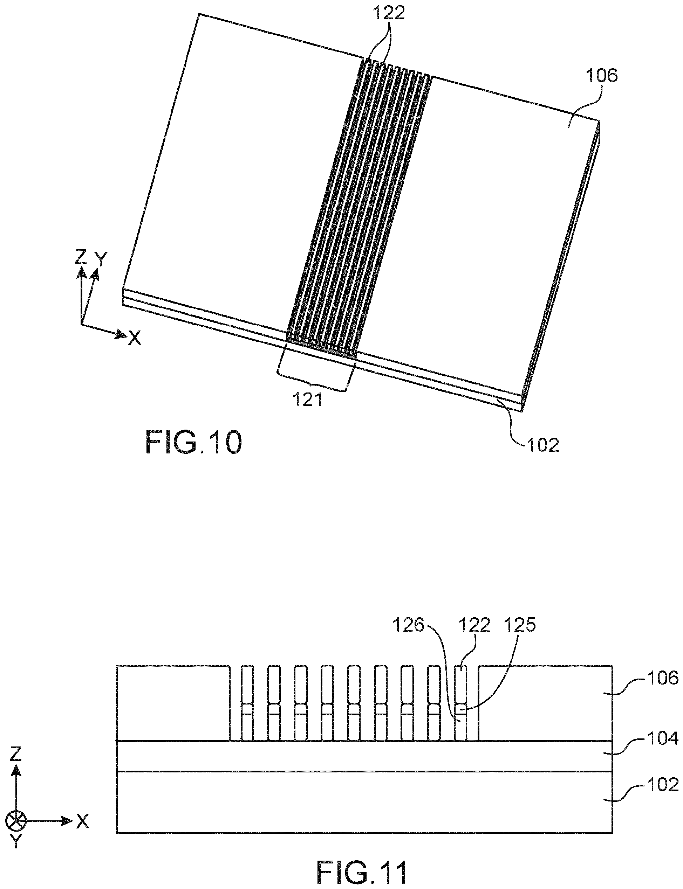

Les deuxièmes lamelles 124 sont alors retirées, par exemple par une gravure similaire à celle précédemment mise en œuvre pour supprimer les deuxièmes lamelles 114, c'est-à-dire par exemple une gravure par plasma O₂ (voir figure 10).

La portion 120 du matériau de grille est ensuite gravée conformément au motif formé par les premières lamelles 122 qui sont les seules encore présentes sur la portion 120. Lorsque la portion 120 de matériau de grille est recouverte de la couche 119, un masque dur 125 est tout d'abord réalisé en utilisant les premières lamelles 122 comme masque. Des agents de gravure différents sont utilisés pour la gravure de la couche 119 et celle du matériau de grille.

A l'issue de la gravure du matériau de grille de la portion 120, les portions restantes de la portion 120 forment des grilles 126 recouvrant les parties 116 de semi-conducteur dans lesquelles les dopants ont été précédemment implantés (voir figure 11).

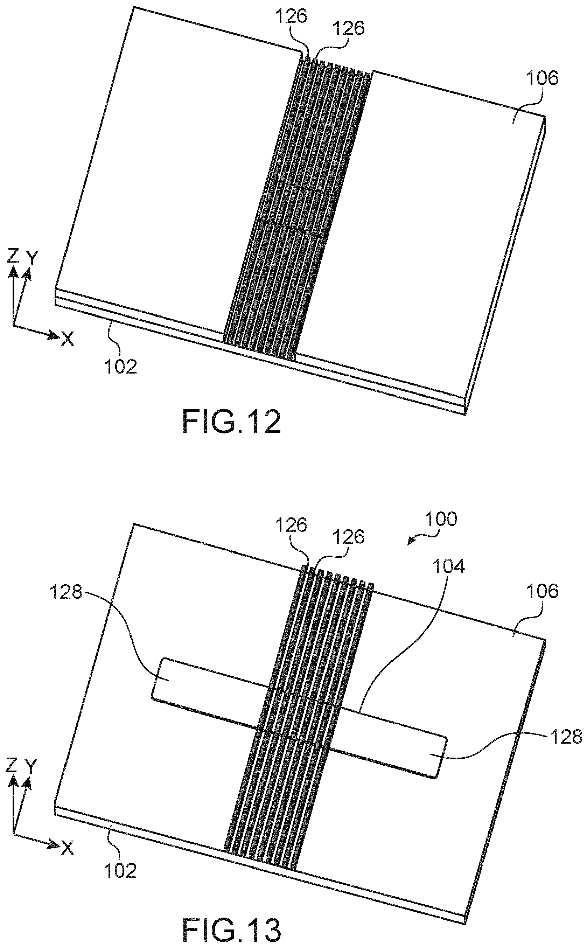

Les premières lamelles 122 sont ensuite retirées, par exemple par une gravure similaire à celle mise en œuvre pour supprimer les première lamelles 112 (voir figure 12).

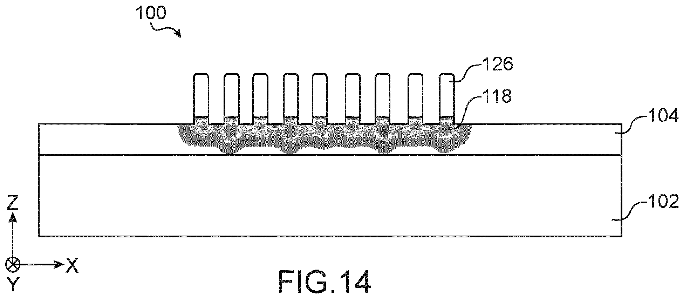

Le guide 106 est ensuite retiré (voir figures 13 et 14), par exemple par gravure. En variante, le guide 106 peut être conservé.

Un dopage peut ensuite être mis en œuvre dans les parties du nanofil 104 qui étaient précédemment recouvertes par le guide 106, ces parties portant la référence 128 sur la figure 13. Ce dopage permet ici de former des réservoirs de charges pour le dispositif 100. En variante, ces parties dopées 128 peuvent être réalisées au début du procédé, avant la réalisation du guide 106.

A l'issue de ces étapes, le dispositif 100 comporte plusieurs boîtes quantiques formées par les parties 116 du nanofil 104 recouvertes chacune par une grille de contrôle 126 réalisée de manière auto-alignée au-dessus de ces parties 116.

Dans le procédé décrit ci-dessus, les étapes mises en œuvre entre la réalisation du guide 106 de grapho-épitaxie et la réalisation des premières et deuxièmes lamelles 122, 124, et notamment les étapes de retrait des lamelles 112, 114, 122, 124 sont mises en œuvre faisant appel à des techniques n'endommageant pas le guide de grapho-épitaxie 106, en particulier ne modifiant pas la largeur « a » de la cavité 108. En effet, une largeur « a » du guide 106 qui soit identique lors de l'assemblage formant les lamelles 112, 114 et lors de l'assemblage formant les lamelles 122, 124 garantit que les emplacements des lamelles 122, 124 sont identiques à ceux des lamelles 112, 114 lorsque le même copolymère diblocs est auto-assemblé. Cela permet donc d'obtenir un auto-alignement des grilles 126 avec les parties 116 de semi-conducteur dans lesquelles les dopants 118 sont implantés. En particulier, les étapes de retrait des lamelles 112, 114, 122, 124 peuvent être réalisées en mettant en œuvre des gravures par plasma car de telles gravures ont pour avantage de graver les copolymères sans détériorer le guide d'assemblage 106, en raison notamment de sa grande sélectivité vis-à-vis du ou des matériaux formant le guide d'assemblage 106.

Dans le mode de réalisation particulier décrit ci-dessus, le matériau de grille est formé dans la cavité 108 après avoir implanté les dopants dans le semi-conducteur. Selon une variante de réalisation, il est possible que le matériau de grille soit formé sur la couche de semi-conducteur avant la réalisation du guide de grapho-épitaxie 106. Dans ce cas, l'implantation de dopants dans le semi-conducteur est réalisée à travers le matériau de grille présent sur le semi-conducteur. Pour la mise en œuvre de cette variante, la nature du matériau de grille et son épaisseur doivent être compatibles avec une telle implantation de dopants. Par exemple, le matériau de grille peut correspondre à une couche de TiN d'épaisseur inférieure ou égale à 10 nm. En outre, dans cette variante, un masque dur peut ne pas être interposé entre le matériau de grille et les premières lamelles 122.

Dans la description ci-dessus, le copolymère à blocs utilisé correspond à un copolymère dibloc. En variante, il est possible que le copolymère à blocs utilisé corresponde à un copolymère autre qu'un copolymère dibloc. Par exemple, il est possible d'utiliser au moins un copolymère tribloc. Dans ce cas, après le premier dépôt du copolymère à blocs dans la cavité du guide de grapho-épitaxie et le premier auto-assemblage du copolymère tribloc formant trois motifs distincts chacun formé par l'une des trois phases du copolymère, l'un des trois motifs formé par une première des trois phases du copolymère est retiré, par exemple par gravure, les deux autres motifs formés par les deux autres phases du copolymère étant conservés. Ensuite, après l'implantation de dopants, le retrait des deux autres motifs, le deuxième dépôt du copolymère à blocs et le deuxième auto-assemblage du copolymère tribloc, les deux autres motifs formés par les deuxièmes et troisièmes phases sont retirés afin de ne conserver que le premier motif formé par la première phase du copolymère et qui sert ensuite à la formation des grilles de commande des qubits.

L'utilisation de copolymère à blocs comprenant plus de deux phases permet de réaliser l'implantation de dopants et la réalisation des grilles de commande avec des motifs autres que des lamelles. Par exemple, les motifs obtenus et servant à l'implantation des dopants peuvent correspondre à un quadrillage carré.

En outre, il est également possible d'utiliser un copolymère à blocs dont l'auto-assemblage forme des motifs autres que des lamelles, par exemple des cylindres.

### Documents cités

B. E. Kane, « A silicon-based nuclear spin quantum computer », Nature 393, 133-137, 14 mai 1998.
C. D. Hill et al., « A surface code quantum computer in silicon », Science Advances, 1, 9 (30 octobre 2015)
G. Tosi et al., « Silicon quantum processor with robust long-distance qubit couplings », Nature Communications, 8, 450, 6 septembre 2017.
T. Shinada et al., « Enhancing semiconductor device performance using ordered dopant arrays », Nature 437, 1128-1131, 20 octobre 2005.
S. R. Schofield et al., « Atomically Precise Placement of Single Dopants in Si », Phys. Rev. Lett. 91, 136104, 25 septembre 2003.
J. J. Pla et al., « A single-atom electron spin qubit in silicon », Nature 489, 541-545, 27 septembre 2012,
M. Koch et al., « Spin read-out in atomic qubits in an all-epitaxial three-dimensional transistor », Nature Nanotechnology, 7 janvier 2019.
L. Oria et al. « Guided self-assembly of block-copolymer for CMOS technology: a comparative study between grapho-epitaxy and surface chemical modification », SPIE 2011, Vol. 7970-24.

## Revendications

1. Procédé de réalisation d'un dispositif (100) quantique à qubits de spin nucléaire, comportant la mise en œuvre des étapes suivantes :
- réalisation, sur une face d'une couche de semi-conducteur, d'un guide (106) de grapho-épitaxie formant au moins une cavité (108) ;
- premier dépôt d'un copolymère à blocs donné dans la cavité (108) du guide (106) de grapho-épitaxie ;
- premier auto-assemblage du copolymère à blocs donné, formant dans la cavité (108) du guide (106) de grapho-épitaxie un premier arrangement (111) d'au moins un premier motif (112) formé par une première phase du copolymère à blocs donné et d'au moins un deuxième motif (114) formé par une deuxième phase du copolymère à blocs donné ;
- retrait du premier motif (112) du premier arrangement (111) ;
- implantation de dopants (118) dans des parties (116) de la couche de semi-conducteur découvertes lors du retrait du premier motif (112) du premier arrangement (111) ;
- retrait du deuxième motif (114) du premier arrangement (111) ;
- deuxième dépôt du copolymère à blocs donné dans la cavité (108) du guide (106) de grapho-épitaxie, recouvrant au moins un matériau de grille (120) réalisé sur la couche de semi-conducteur entre le retrait du deuxième motif (114) du premier arrangement (111) et le deuxième dépôt du copolymère à blocs donné, ou avant la réalisation du guide (106) de grapho-épitaxie ;
- deuxième auto-assemblage du copolymère à blocs donné, formant dans la cavité (108) du guide (106) de grapho-épitaxie un deuxième arrangement (121) d'au moins un premier motif (122) formé par la première phase du copolymère à blocs donné et d'au moins un deuxième motif (124) formé par la deuxième phase du copolymère à blocs donné, similaires à ceux du premier arrangement (111) ;
- retrait du deuxième motif (124) du deuxième arrangement (121);
- gravure de premières portions du matériau de grille (120) découvertes lors du retrait du deuxième motif (124) du deuxième arrangement (121), telle que des deuxièmes portions (126) restantes du matériau de grille localisées sous le premier motif (122) du deuxième arrangement (121) forment des grilles de commande des qubits ;
- retrait du premier motif (122) du deuxième arrangement (121).

2. Procédé selon la revendication 1, dans lequel le copolymère à blocs donné est un copolymère dibloc.

3. Procédé selon l'une des revendications précédentes, dans lequel la cavité (108) comporte, dans un plan parallèle à la face de la couche de semi-conducteur, une dimension latérale égale à un multiple d'une période d'auto-assemblage en lamelles du copolymère à blocs donné, et dans lequel les premier et deuxième arrangements (111, 121) correspondent à des arrangements alternés de premières lamelles correspondant au premier motif (112, 122) et de deuxièmes lamelles correspondant au deuxième motif (114, 124).

4. Procédé selon la revendication 3, dans lequel la couche de semi-conducteur est disposée sur un substrat (102), et le procédé comporte en outre, avant la réalisation du guide (106) de grapho-épitaxie, une gravure de la couche de semi-conducteur telle qu'au moins une portion restante (104) de la couche de semi-conducteur forme un nanofil ayant une plus grande dimension qui est parallèle à la dimension latérale de la cavité (108).

5. Procédé selon l'une des revendications précédentes, comportant en outre la mise en œuvre d'un dopage de parties (128) de la couche de semi-conducteur différentes de celles découvertes lors du retrait du premier motif (112) du premier arrangement (111).

6. Procédé selon l'une des revendications précédentes, dans lequel le premier auto-assemblage et/ou le deuxième auto-assemblage du copolymère à blocs donné comporte la mise en œuvre d'un recuit du copolymère à blocs donné.

7. Procédé selon l'une des revendications précédentes, dans lequel l'implantation de dopants (118) comporte la mise en œuvre d'une implantation ionique.

8. Procédé selon l'une des revendications précédentes, dans lequel le matériau de grille (120) est réalisé sur la couche de semi-conducteur entre le retrait du deuxième motif (114) du premier arrangement (111) et le deuxième dépôt du copolymère à blocs donné et comporte du polysilicium, ou dans lequel le matériau de grille (120) est réalisé sur la couche de semi-conducteur avant la réalisation du guide (106) de grapho-épitaxie et comporte du polysilicium et/ou un matériau métallique dont l'épaisseur soit telle que l'implantation de dopants puisse être réalisée à travers le matériau de grille (120).

9. Procédé selon l'une quelconque des revendications précédentes, dans lequel le procédé comprend un dépôt d'une couche (119) de masque dur sur le matériau de grille (120) avant le deuxième dépôt du copolymère à blocs donné, et comportant en outre, entre le retrait du deuxième motif (124) du deuxième arrangement (121) et la gravure des premières portions du matériau de grille, une gravure de parties de la couche (119) de masque dur précédemment recouvertes par le deuxième motif (124) du deuxième arrangement (121).

10. Procédé selon l'une des revendications précédentes, dans lequel la couche de semi-conducteur comporte du silicium 28 isotopiquement purifié.

11. Procédé selon l'une des revendications précédentes, dans lequel les dopants implantés dans les premières parties de la couche de semi-conducteur correspondent à des atomes de phosphore.
